# EUROPEAN PATENT SPECIFICATION

(11) **EP 4 198 554 B1**
(45) Date of publication and mention of the grant of the patent: **16.09.2026**
(21) Application number: 21306783.8
(22) Date of filing: 15.12.2021
(51) Int. Cl.: G01S 7/481, G01S 17/08, H04M 1/02, H10K 59/00

(54) **ASSEMBLY COMPRISING A DISPLAY SCREEN AND A PROXIMITY SENSOR**
ANORDNUNG MIT EINEM BILDSCHIRM UND EINEM NÄHERUNGSSENSOR
ENSEMBLE COMPRENANT UN ÉCRAN D'AFFICHAGE ET UN CAPTEUR DE PROXIMITÉ

(43) Date of publication of application: 21.06.2023
(73) Proprietor: STMicroelectronics (Research & Development) Limited, Buckinghamshire SL7 1EY (GB); STMicroelectronics (Grenoble 2) SAS, 38000 Grenoble (FR); STMicroelectronics (ALPS) SAS, 38000 Grenoble (FR)
(72) Inventor: HANNAN, Joseph, 00910 HELSINKI (FI); CALEY, Adam, FIFE, FK10 4QX (GB); GUILLON, Megane, 38120 SAINT-EGREVE (FR); MILANETTO, Charlotte, 38000 GRENOBLE (FR); PREMONT, Christophe, 38360 NOYAREY (FR)
(74) Representative: Cabinet Beaumont

(56) References cited:
- US-A1- 2015 001 414
- US-A1- 2020 209 055
- US-A1- 2020 209 729
- US-A1- 2021 216 163
- US-A1- 2021 373 132

## Description

### Technical field

The present disclosure relates generally to electronic devices, more particularly, to electronic devices comprising a display screen and a proximity sensor.

### Background art

Electronic devices, such as mobile phones, e.g. smartphones, tablet computers, smartwatches, touchpads, laptop computers, comprising a screen displaying information and/or images destined for a user, for example a user of the device, are known.

Electronics devices comprising an optical package such as a proximity sensor are also known. A proximity sensor generally comprises an optical light emitter and an optical detector, generally housed in an optical package. The general principle of a proximity sensor is that the light emitter emits a light beam which is reflected on a target object and picked up by the optical detector. The optical detector may also be provided with other circuitry provided as part of said detector or associated therewith, which analyzes the output from said detector for a proximity sensing calculation.

US2021373132A1 describes an optical sensor arrangement, device and method of manufacturing an optical sensor arrangement. US20150001414A1 describes a proximity sensor. US2020209055A1 describes an optical sensor arrangement. US2020209729A1 describes through-display optical transmission, reception, or sensing through micro-optic elements. US2021216163A1 an apparatus integrated with display panel for TOF 3D spatial positioning.

The optical light emitter may comprise a light emitting diode (LED), a vertical cavity surface emitting laser (VCSEL) or an edge emitting laser (EEL).

The proximity sensor may be a time-of-flight (TOF) sensor type. For instance, TOF sensors generally comprise a VCSEL for emitting light radiation, and an array of Single Photon Avalanche Detectors (SPADs) or photodiodes for detecting the reflected light beam from the target object.

For certain applications, it is desired to mount a proximity sensor on the same side of an electronic device as a display screen. In some cases, the proximity sensor can be positioned within a bezel which corresponds to a non-display area in a border region reserved for such devices, or a notch in the display screen. However, in order to increase the area of the display screen, it has been proposed to dispense with such a bezel or such a notch, and instead to place the proximity sensor behind the display screen, such that the optical light emitter transmits light through the display screen, and the optical detector picks up the emitted light after being reflected by a target object through the display screen again.

The display screen may be an organic light-emitting diode (OLED) type screen.

Regrettably, an unwanted diffraction of the light passing through a display screen, for instance through an OLED screen, has been observed when the light is emitted and received by the proximity sensor through the display screen. The diffraction effect increases the crosstalk effect between the emitter and the sensor, which has a drawback of degrading the performances of the proximity sensor, due to unwanted (noise) optical reflection component caused by the reflection of the emitted optical light from a non-target object, such as a cover glass or an internal structure of the OLED screen, in addition to the useful optical reflection component caused by the reflection of the emitted optical signal at the target object.

### Summary of Invention

There is a need for an assembly for an electronic device, comprising at least a display screen and a proximity sensor under the display screen, capable of limiting, or even suppressing, the aforementioned crosstalk effect due to the diffraction effect.

It would also be desirable that the solution is easy to implement.

One embodiment addresses all or some of the drawbacks of known electronic devices.

According to the invention, is provided an assembly for an electronic device, the assembly comprising:
- a display screen comprising a plurality of pixels arranged in a matrix scheme comprising rows orientated in a first direction and columns orientated in a second direction; the display screen being an OLED screen, each pixel of the OLED screen having a subpixel arrangement; and
- a proximity sensor comprising at least one optical light emitter, each adapted to emit a light beam through one or more first pixels of the display screen, and an optical detector adapted to receive through one or more second pixels of the display screen the light beam emitted by the at least one optical light emitter and reflected on an object;
wherein none of the one or more second pixels is in the same row as any of the one or more first pixels, and none of the one or more second pixels is in the same column as any of the one or more first pixels.

According to an embodiment, each common axis passing through the center of one of the at least one optical light emitter and the center of the optical detector is offset with regard to each of the first and second directions by an acute angle of at least 10° and at most 80°.

According to an embodiment, a first acute angle of the common axis with regard to the first direction is comprised between 10° and 45°.

According to an embodiment, a second acute angle of the common axis with regard to the second direction is comprised between 10° and 45°.

According to an embodiment, the subpixel arrangement is a pentile subpixel arrangement.

According to an embodiment, the at least one optical light emitter and the optical detector are housed within an optical package, and each common axis passing through the center of one of the at least one optical light emitter and the center of the optical detector is substantially aligned with an edge of the optical package.

According to an embodiment, the at least one optical light emitter and the optical detector are housed within an optical package, and each common axis passing through the center of one of the at least one optical light emitter and the center of the optical detector is offset with regard to each of the edges of the optical package by an acute angle of at least 10° and at most 80°.

According to an embodiment, the optical package is substantially rectangular or square, and at least a common axis is substantially orientated substantially in a diagonal of the optical package.

According to an embodiment, the optical detector comprises an array of light sensitive pixels having rows and columns of light sensitive pixels, said optical detector being orientated in order to align said rows of light sensitive pixels or said columns of light sensitive pixels substantially in the direction of the common axis.

According to an embodiment, the proximity sensor comprises at least two optical light emitters.

In one embodiment, is provided an electronic device comprising the assembly according to an embodiment.

According to the invention, is provided a method for forming an assembly comprising a display screen having a plurality of pixels arranged in a matrix scheme comprising rows orientated in a first direction and columns orientated in a second direction, and a proximity sensor; the display screen being an OLED screen, each pixel of the OLED screen having a subpixel arrangement; the proximity sensor having at least one optical light emitter and an optical detector; the method comprising: placing the proximity sensor under the display screen, such that each of the at least one optical light emitter is adapted to emit a light beam through one or more first pixels of the display screen, the optical detector is adapted to receive through one or more second pixels of the display screen the light beam emitted by the at least one emitter and reflected on an object, none of the one or more second pixels being in the same row as any of the one or more first pixels, and none of the one or more second pixels being in the same column as any of the one or more first pixels.

According to an embodiment, the method comprises:
- providing the prproximity sensor having the at least one optical light emitter and the optical detector both housed within an optical package, each common axis passing through the center of one of the at least one optical light emitter and the center of the optical detector being substantially aligned with an edge of the optical package;
- positioning the proximity sensor under the display screen;
- rotating the proximity sensor in order to offset the edge of the optical package with regard to each of the first and second directions by an acute angle of at least 10° and at most 80°; and
- assembling the proximity sensor to the display screen.

According to an embodiment, the method comprises:
- providing the proximity sensor having the at least one optical light emitter and the optical detector both housed within an optical package, each common axis passing through the center of one of the at least one optical light emitter and the center of the optical detector being offset with regard to each of the edges of the optical package by an acute angle of at least 10° and at most 80°; and
- assembling the proximity sensor under the display screen so that each of the edges of the optical package is substantially aligned with the first direction or the second direction.

### Brief description of drawings

The foregoing features and advantages, as well as others, will be described in detail in the following description of specific embodiments given by way of illustration with reference to the accompanying drawings, in which:
[Fig. 1A] schematically illustrates an assembly comprising an OLED screen and a proximity sensor placed under the OLED screen;
[Fig. 1B] shows a diffraction pattern observed when a light beam is emitted and received through an OLED screen;
[Fig. 1C] schematically illustrates a crosstalk path induced by a light beam emitted from a proximity sensor through an OLED screen in the assembly of figure 1A;
[Fig. 2] schematically illustrates an embodiment of an assembly for an electronic device;
[Fig. 3] schematically illustrates another embodiment of an assembly for an electronic device;
[Fig. 4A] schematically illustrates another embodiment of an assembly for an electronic device;
[Fig. 4B] schematically illustrates a variant of the embodiment of figure 4A;
[Fig. 5] schematically illustrates a reflection pattern emitted from a proximity sensor through an OLED screen in an assembly according to an embodiment;
[Fig. 6] represents measurements of the crosstalk effect for different angles between the common angle of an optical light emitter and an optical detector in an assembly of an electronic device and the major axis of the electronic device.

### Description of embodiments

Like features have been designated by like references in the various figures. In particular, the structural and/or functional features that are common among the various embodiments may have the same references and may dispose identical structural, dimensional and material properties.

For the sake of clarity, only the operations and elements that are useful for an understanding of the embodiments described herein have been illustrated and described in detail. In particular, the other components of an assembly or an electronic device integrating a display screen and a proximity sensor have not been detailed, the described embodiments being compatible with the usual other components of assemblies or electronic devices comprising a display screen. Similarly, the proximity sensor, in particular the optical light emitter(s) and the optical detector, and other components of a proximity sensor, have not been detailed.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

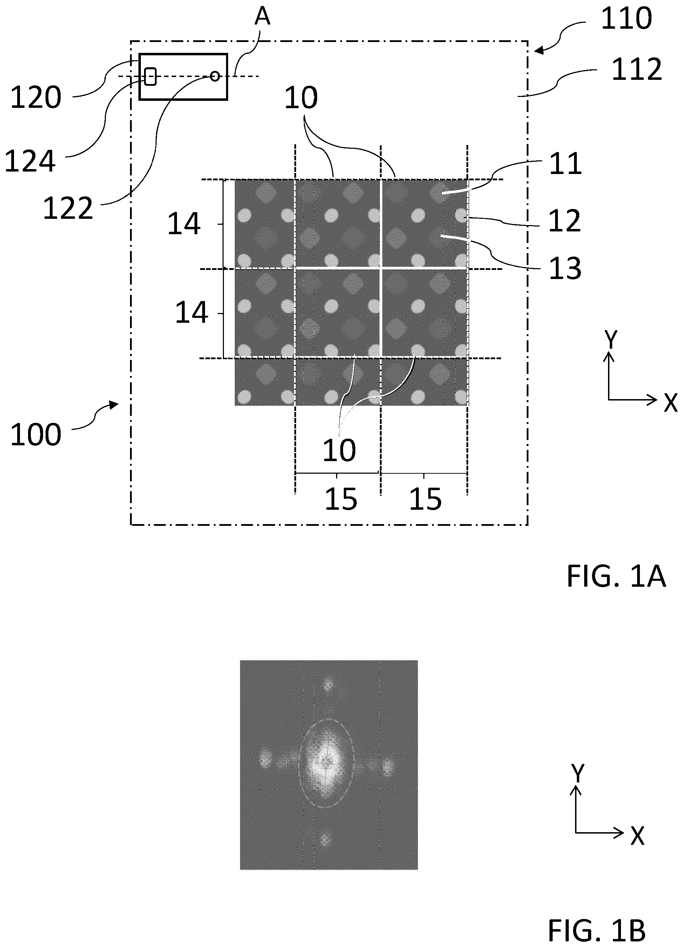

Referring to an electronic device such as a mobile phone, a tablet computer, a smartwatch, a touchpad, more generally to an electronic device having a substantially rectangular shape, the horizontal orientation (direction "X" in figures 1A, 1B, 2, 3, 4A) corresponds for example to the minor axis of the electronic device, while the vertical orientation (direction "Y" in figures 1A, 1B, 2, 3, 4A) corresponds for example to the major axis.

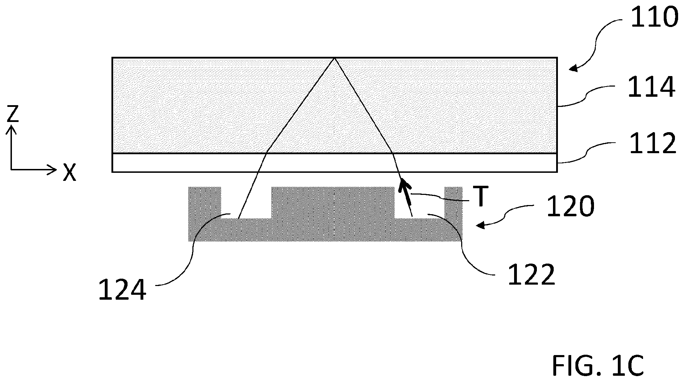

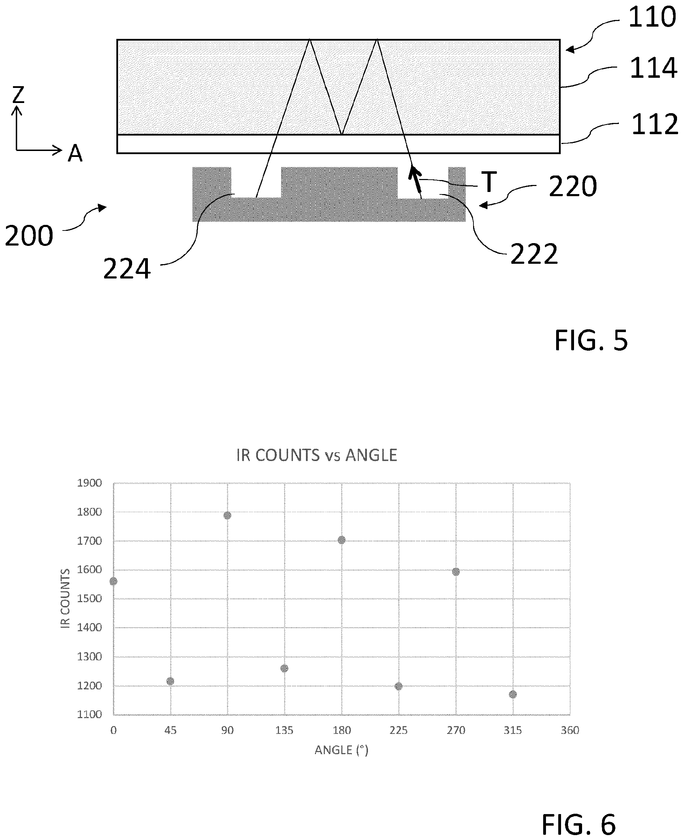

In addition, the terms "under" and "over" refer to the light propagation direction from the optical light emitter to the display screen (direction materialized by a thick horizontal arrow referenced "T" in figures 1C and 5). The term "under" means before the display screen in the light propagation direction, and the term "over" means after the display screen in the light propagation direction.

Unless specified otherwise, the expressions "around", "approximately", "substantially" and "in the order of" signify within 10 %, and preferably within 5 %.

Figure 1A schematically illustrates an assembly 100 comprising an OLED display screen 110 having an OLED layer 112, and a proximity sensor 120 placed under the OLED layer 112. The OLED display screen 110 comprises generally a cover glass 114 on the OLED layer 112, as illustrated in figure 1C.

In this example, the OLED layer 112 has a diamond pentile subpixel arrangement, shown partially, and enlarged, in the OLED layer 112 of figure 1A for sake of clarity. As illustrated, a diamond pentile subpixel arrangement is a geometric arrangement of RGB (Red, Green, Blue) subpixels 11, 12, 13 in each pixel 10 of the OLED layer, in which the green pixels 12 interleave with alternating red 11 and blue 13 subpixels, with twice as many green subpixels as blue subpixels and red subpixels. The blue subpixels 13 are the largest subpixels, followed closely by the red subpixels 11, the greens subpixels 12 being much smaller than the red and the blue subpixels. Other shapes and/or arrangements of subpixels may be provided in the OLED layer, such as circular shapes and/or other pentile subpixel arrangements, or even common or alternated stripes arrangements.

The pixels 10 of the OLED layer are arranged in rows 14 and columns 15, this arrangement being key to the diffraction orientation, as explained hereafter. The rows are orientated in the horizontal direction X and the columns are orientated in the vertical direction Y.

The proximity sensor 120 comprises an optical light emitter 122 and an optical detector 124. The common axis A of the system formed by the optical light emitter and the optical detector, corresponding to the axis between the center of the optical light emitter and the center of the optical detector, is aligned with the horizontal direction X which corresponds to the direction of the rows 14 of pixels.

Figure 1B shows a diffraction pattern observed when a light beam is emitted and received through an OLED layer 112.

The inventors have measured diffraction order angles for a light beam of a given wavelength, and determined a diffractive structure pitch, using the relation:
$d \times sin θ = m \times λ$ where d is the pitch of the diffractive structure, θ is the diffraction angle, m is the order number, and *λ* is the wavelength, for instance 940 nm.

The inventors have determined that the pitch of the diffractive structure was very close to the pitch between the subpixels of the OLED layer in the row and column directions. The pitch between the subpixels is for example measured as the distance between two adjacent subpixels in the row direction or in the column direction. Thus, the inventors assume that the diffraction is caused by the pixels, and particularly the subpixels, of the OLED layer, in other words, that the diffraction structure is formed by the subpixels of the OLED layer.

In addition, the inventors have noticed that the diffraction effect is more pronounced in the X direction and in the Y direction, corresponding respectively to the row orientation and the column orientation of the pixel arrangement, also corresponding to the two directions of the alternance of the red and blue subpixels.

Indeed, the diffraction structure in the OLED layer creates higher angles of emission along the X direction or the Y direction. As illustrated in figure 1C, higher angles mean that light can traverse from the emitter 122 to the detector 124 in fewer reflections in the cover glass 114 above the OLED layer 112, and thus, is less attenuated. For example, there is one reflection (bounce) in the illustrated case. If the angles are high enough, total internal reflection occurs and minimal attenuation occurs, inducing a crosstalk effect.

This diffraction effect increases the screen crosstalk contribution if the proximity sensor is orientated such that the emitter and detector common axis A is aligned in one of these two directions, as illustrated in figure 1A, which has a drawback of degrading the performances of the proximity sensor.

The inventors also assume that metallization of the pixels routing is important in creating the diffraction patterns. In particular, they assume that the pixels routing of metal in the row and column orientations are different, leading to different diffraction patterns in the X and Y directions.

The inventors propose an assembly and a proximity sensor making it possible to overcome all or part of the aforementioned drawbacks, in particular to limit, or even suppress, the aforementioned crosstalk effect due to the diffraction effect.

Embodiments of assemblies and proximity sensors will be described below.

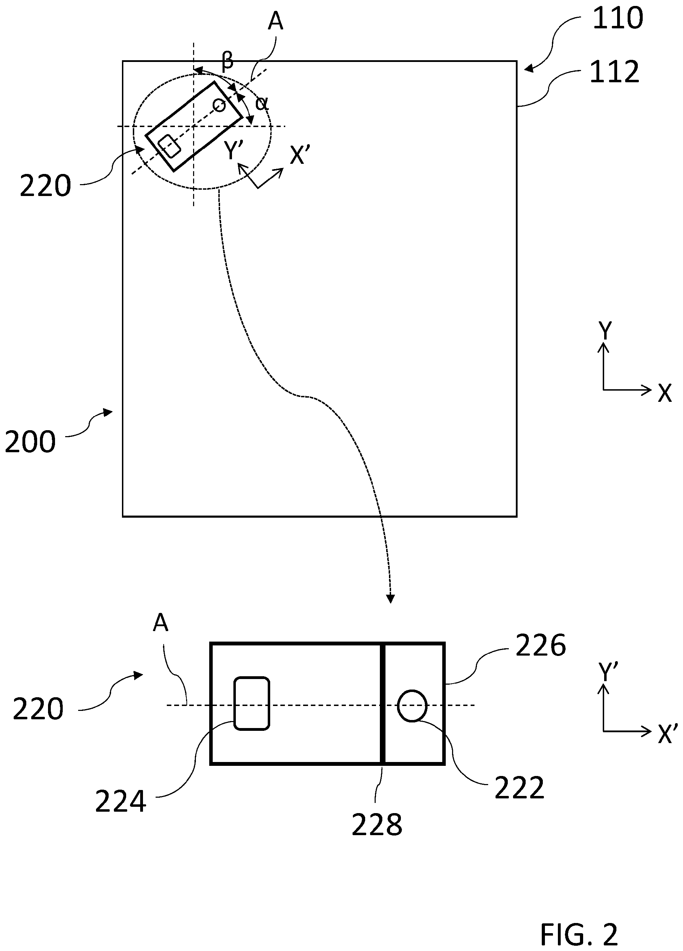

Figure 2 illustrates an embodiment of an assembly 200 comprising a display screen 110 having a display layer 112, and a proximity sensor 220 under the display layer 112.

The display layer 112 and the display screen 110 have a rectangular shape, the two opposite larger edges extending in a major axis Y (vertical direction), and the two opposite smaller edges extending in a minor axis X (horizontal direction) .

The display screen is an OLED display screen, and the display layer is an OLED layer, as the one described in relation with figure 1A. The OLED display screen 110 may comprise a cover glass 114 on the OLED layer 112, as described for example in relation with figure 1C.

Referring to the OLED layer 112 of figure 1A, the OLED layer comprises pixels 10 arranged in rows 14 and columns 15. The rows are orientated in the horizontal direction X and the columns are orientated in the vertical direction Y.

The proximity sensor 220 comprises an optical light emitter 222 and an optical detector 224, both housed within an optical package 226.

The proximity sensor may be a time-of-flight (TOF) sensor type. The proximity sensor may be an intensity based sensor type.

The optical light emitter may be a VCSEL. It will be understood that any type of optical light emitter may be used, for instance a LED emitter.

The optical detector may be of any type of suitable optical detector. For example, the optical detector may include a single light sensitive pixel comprising a photodiode or a plurality of light sensitive pixels, each pixel comprising a photodiode. The proximity detector may include, or may be, a single photon avalanche detector (SPAD).

The optical package 226 and therefore the proximity sensor 220 have a rectangular shape, the two opposite larger edges extending in a major axis X' corresponding to an horizontal direction in the referential of the proximity sensor, and the two opposite smaller edges extending in a minor axis Y' corresponding to a vertical direction in the referential of the proximity sensor. The axis X' and Y' form the main plane of the proximity sensor 220.

The optical light emitter 222 and the optical detector 224 can be separated by a septum 228 internal to the optical package, the septum 228 being substantially parallel to the minor axis Y' of the proximity sensor 220.

The common axis A passing through the center of the optical light emitter 222 and the center of the optical detector 224 is substantially aligned with the major axis X' of the proximity sensor 220. In addition, the proximity sensor 220 is angularly offset with regard to the horizontal and vertical directions X, Y of the display screen 110, which correspond to the orientations of the rows and columns of pixels in the display layer 112. In other words, each of the axis X', Y' of the proximity sensor 220 is offset with regard to each of the horizontal and vertical directions X, Y of the display screen. More precisely, in the illustrated embodiment, the major axis X' of the proximity sensor is offset with regard to the horizontal direction X (minor axis) of the display screen by a first acute angle α, and is offset with regard to the vertical direction Y (major axis) of the display screen by a second acute angle β, the second acute angle being complementary to the first acute angle.

The first acute angle α is preferably higher than around 10° and preferably lower than around 80°, for example comprised between around 10° and 45°, for instance equal to around 45°.

The result is that the common axis A passing through the center of the optical light emitter 222 and the center of the optical detector 224 is angularly offset with regard to each of the orientations of the rows and columns of pixels of the display screen, thus allowing the crosstalk effect, due to the diffraction effect, to be limited, and even suppressed.

In other words, when the optical light emitter 222 emits a light beam through one or more first pixels of the display screen 110, and the optical detector 224 receives through one or more second pixels of the display screen 110 the light beam emitted by the emitter and reflected on an object, none of the one or more second pixels is in the same row as any of the one or more first pixels and none of the one or more second pixels is in the same column as any of the one or more first pixels.

The assembly 200 of figure 2 can be obtained by providing a proximity sensor, such as the one of figure 1A, and rotating it before assembling it behind the display screen 110, in order to angularly offset said proximity sensor with regard to the horizontal and vertical directions X, Y of the display screen 110, which correspond to the orientations of the rows and columns of pixels in the display layer 112.

In another embodiment, the orientations of the rows and columns of the display layer are not in the horizontal and vertical directions of the display screen. In this another embodiment, the proximity sensor is orientated in order to be offset with regard to each of the orientations of the rows and columns of the display layer.

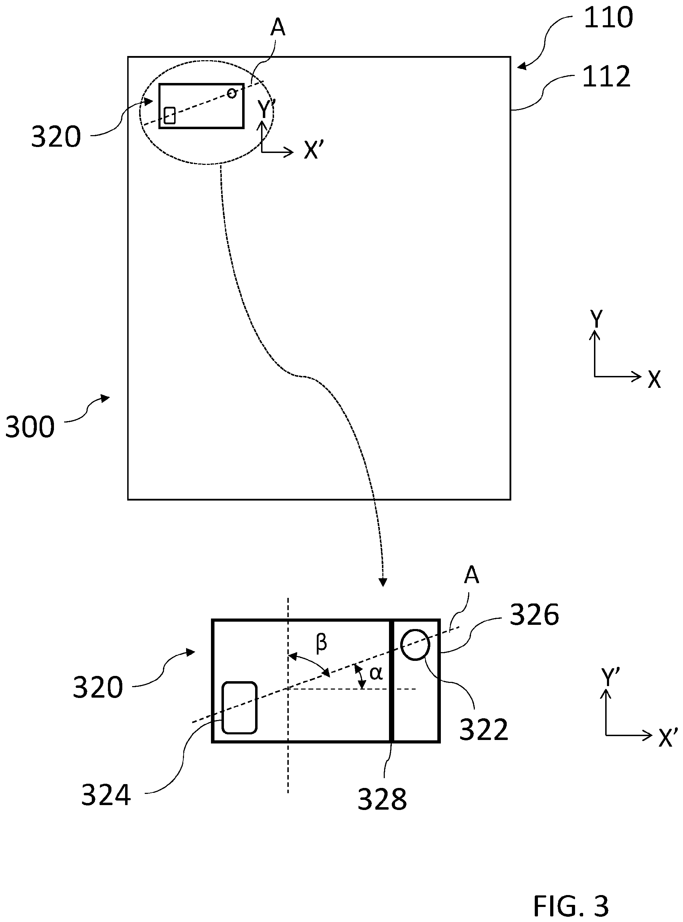

Figure 3 illustrates another embodiment of an assembly 300 which differs from that of figure 2 in that the common axis A passing through the center of the optical light emitter 322 and the center of the optical detector 324 is offset with regard to the major axis X' of the optical package 326 by a first acute angle α, and is offset with regard to the minor axis Y' of the optical package by a second acute angle β, the second acute angle being complementary to the first acute angle. In addition, the major axis X' of the proximity sensor 320 is substantially aligned with regard to the horizontal direction X (minor axis) of the display screen and the minor axis Y' of the proximity sensor 320 is substantially aligned with the vertical direction Y (major axis) of the display screen.

The first acute angle α is preferably higher than around 10°, and preferably lower than around 80°, for example comprised between around 10° and 45°, for example equal to around 45°.

Since the horizontal direction X of the display screen 110 corresponds to the orientation of the rows of pixels in the display layer 112 and the vertical direction Y of the display screen 110 corresponds to the orientation of the columns of pixels in the display layer 112, the result is that the common axis A passing through the center of the optical light emitter 322 and the center of the optical detector 324 is angularly offset with regard to each of the row and column orientations of the display layer 112, thus allowing the crosstalk effect due to the diffraction effect, to be limited, an even suppressed.

In other words, when the optical light emitter 322 emits a light beam through one or more first pixels of the display screen 110, and the optical detector 324 receives through one or more second pixels of the display screen 110 the light beam emitted by the emitter and reflected on an object, none of the one or more second pixels is in the same row as any of the one or more first pixels and none of the one or more second pixels is in the same column as any of the one or more first pixels.

In comparison with the proximity sensor 220 of figure 2, the proximity sensor 320 of figure 3 can be obtained by offsetting the light emitter 322 and the optical detector 324 with regard to the major axis X' of the optical package 326 before closing and/or encapsulating them to form the optical package.

Similarly to the proximity sensor 220 of figure 2, the optical light emitter 322 and the optical detector 324 can be separated by a septum 328 internal to the optical package 326, the septum 328 being substantially parallel to the minor axis Y' of the proximity sensor 320.

The other features and embodiments described above for the assembly of figure 2 may also be applied to the assembly of figure 3.

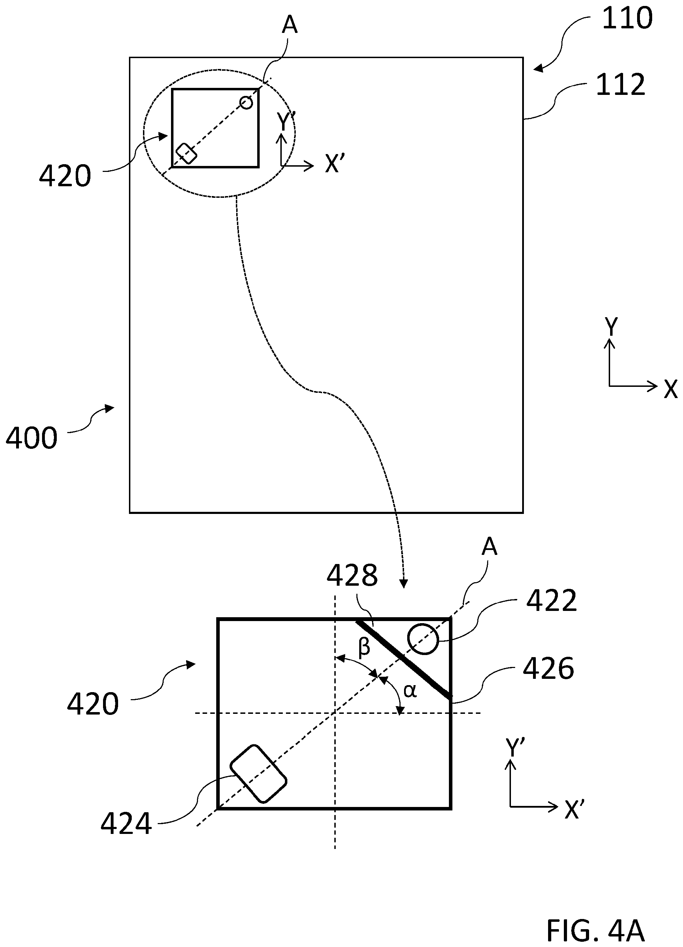

Figure 4A illustrates another embodiment of an assembly 400 which differs from that of figure 3 in that the common axis A passing through the center of the optical light emitter 422 and the center of the optical detector 424 is substantially orientated in a diagonal of the optical package 426, which has a substantially square form. In addition, an optical detector 424 having an array of light sensitive pixels comprising rows and columns of light sensitive pixels is for instance orientated in order to align the rows of light sensitive pixels or the columns of light sensitive pixels substantially in the direction of the common axis A.

In the illustrated embodiment, the first acute angle α is equal to around 45°. In other embodiments, the first acute angle α can be comprised between around 10° and 80°, for example comprised between around 10° and 45°.

The proximity sensor 420 of figure 4A can be obtained by providing a Printed Circuit Board (PCB) or another substrate having substantially a square form, placing the light emitter 422 and the optical detector 424 on the PCB or substrate so that the common axis A passing through the center of the optical light emitter 422 and the center of the optical detector 424 is substantially orientated in a diagonal of said PCB or substrate, before closing with a cover and/or encapsulating the light emitter and the optical detector on the PCB or substrate to form an optical package 426.

In addition, an optical detector 424 having an array of light sensitive pixels comprising rows and columns of light sensitive pixels is for example rotated before forming the optical package, in order to align the rows of light sensitive pixels or the columns of light sensitive pixels in the direction of the common axis A.

The optical light emitter 422 and the optical detector 424 can be separated by a septum 428 internal to the optical package 426, the septum 428 being orientated substantially perpendicular to the common axis A (substantially perpendicular to the diagonal).

In another embodiment, the optical package 426 may have a rectangular form.

The other features and embodiments described above for the assembly of figure 2 or figure 3 may also be applied to the assembly of figure 4A.

The proximity sensor may comprise multiple optical light emitters. In this case, a common axis is an axis passing through the center of one of the multiple optical light emitters and the center of the optical detector, and each common axis is preferably offset with regard to each of the row and column directions of the pixels in the matrix scheme. The same applies if there are multiple optical detectors, in which a common axis is an axis passing through the center of one of the multiple optical light emitters and the center of one of the optical detector. These cases can apply to any of the embodiments.

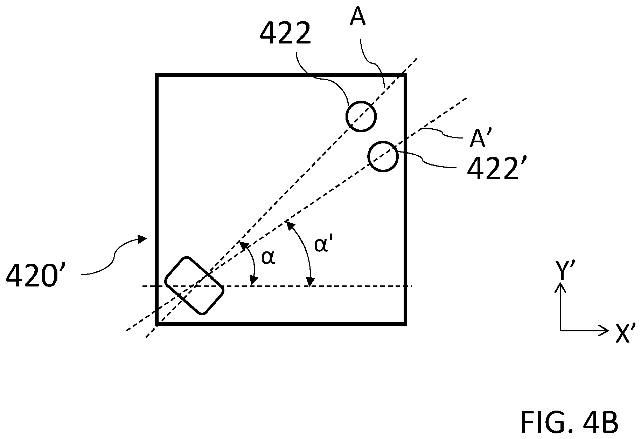

As an example, figure 4B illustrates a variant of the embodiment of figure 4A which differs mainly in that the proximity sensor 420' comprises two optical light emitters 422, 422'. In addition, a first common axis A passing through the center of a first optical light emitter 422 and the center of the optical detector 424 is offset with regard to the major axis X' by a first acute angle α and a second common axis A' passing through the center of a second optical light emitter 422' and the center of the optical detector 424 is offset with regard to the major axis X' by a second acute angle α'. Each of the first and second acute angles can be comprised between around 10° and 80°, for example comprised between around 10° and 45°.

Figure 5 schematically illustrates a reflection pattern of a light beam emitted from a proximity sensor 220 through an OLED screen 110 in an assembly 200 according to an embodiment. The assembly of figure 5 is referred as being the one of figure 2, but it could be any assembly according to an embodiment.

Since the common axis A passing through the center of the optical light emitter 222 and the center of the optical detector 224 is angularly offset with regard to each of the row and column orientations of the OLED layer 112, the proximity sensor 220 is less subjected to the diffraction effect induced by the pixel scheme in the OLED layer, which acts as a diffraction structure. Indeed, in the directions offset with regard to the row and column directions, the OLED layer 112 creates lower angles of emission. Therefore, there are at least three bounces of the light beam in the coverglass 114, further attenuating the diffraction effect in these directions (for example, attenuation of a 25 factor per bounce, given that three bounces are illustrated but it could be more than three, such as five or seven).

Figure 6 represents measurements of the crosstalk effect (counts) for different angles, in the trigonometric direction, measured between the vertical direction Y of a display screen and the common axis A of a proximity sensor, the proximity sensor being under the display screen, with light beams emitted and received by the proximity sensor passing through the display screen.

The measurements are also shown in table 1 below, in which the corresponding acute angle β (with regard to the vertical direction Y of the display screen) and the corresponding acute angle α (with regard to the horizontal direction X of the display screen) are given in two other columns.

**Table 1**

| Measured angle | Corresponding acute angle β | Corresponding acute angle α | Counts |
|---|---|---|---|
| 0° | 0° | 90° | 1560 |
| 45° | 45° | 45° | 1216 |
| 90° | 90° | 0° | 1788 |
| 135° | 45° | 45° | 1260 |
| 180° | 0° | 90° | 1703 |
| 225° | 45° | 45° | 1198 |
| 270° | 90° | 0° | 1593 |
| 315° | 45° | 45° | 1170 |

The measurements show that the counts are higher when the common axis A is orientated in the vertical direction Y or in the horizontal direction X, but lower when the common axis A is orientated between the vertical direction Y and the horizontal direction X, thus proving the positive effect of offsetting the common axis A.

Various embodiments and variants have been described. In examples not according to the invention the assembly and the electronic device could comprise other display screens, the pixels of which induce the diffraction of a light beam passing through.

Finally, the practical implementation of the embodiments and variants described herein is within the capabilities of those skilled in the art based on the functional description provided hereinabove.

## Claims

1. An assembly (200, 300, 400) for an electronic device, the assembly comprising:
- a display screen (110) comprising a plurality of pixels (10) arranged in a matrix scheme comprising rows (14) orientated in a first direction (X) and columns (15) orientated in a second direction (Y); the display screen being an OLED screen, each pixel of the OLED screen having a subpixel arrangement; and
- a proximity sensor (220, 320, 420, 420') comprising at least one optical light emitter (222, 322, 422, 422'), each adapted to emit a light beam through one or more first pixels of the display screen, and an optical detector (224, 324, 424) adapted to receive through one or more second pixels of the display screen the light beam emitted by the at least one optical light emitter and reflected on an object;
wherein none of the one or more second pixels is in the same row as any of the one or more first pixels, and none of the one or more second pixels is in the same column as any of the one or more first pixels.

2. The assembly (200, 300, 400) according to claim 1, wherein each common axis (A, A') passing through the center of one of the at least one optical light emitter (222, 322, 422, 422') and the center of the optical detector (224, 324, 424) is offset with regard to each of the first and second directions (X, Y) by an acute angle of at least 10° and at most 80°.

3. The assembly according to claim 2, wherein a first acute angle (α, α') of the common axis (A, A') with regard to the first direction (X) is comprised between 10° and 45°.

4. The assembly according to claim 2, wherein a second acute angle (β) of the common axis (A) with regard to the second direction (Y) is comprised between 10° and 45°.

5. The assembly according to any one of claims 1 to 4,wherein the subpixel arrangement is a pentile subpixel arrangement.

6. The assembly (200) according to any one of claims 1 to 5, wherein the at least one optical light emitter (222) and the optical detector (224) are housed within an optical package (226), and each common axis (A) passing through the center of one of the at least one optical light emitter and the center of the optical detector is substantially aligned with an edge of the optical package.

7. The assembly (300, 400) according to any one of claims 1 to 6, wherein the at least one optical light emitter (322, 422, 422') and the optical detector (324, 424) are housed within an optical package (326, 426), and each common axis (A, A') passing through the center of one of the at least one optical light emitter and the center of the optical detector is offset with regard to each of the edges of the optical package by an acute angle of at least 10° and at most 80°.

8. The assembly (400) according to claim 7, wherein the optical package (426) is substantially rectangular or square, and at least a common axis (A) is substantially orientated substantially in a diagonal of the optical package.

9. The assembly (400) according to claim 8, wherein the optical detector (424) comprises an array of light sensitive pixels having rows and columns of light sensitive pixels, said optical detector being orientated in order to align said rows of light sensitive pixels or said columns of light sensitive pixels substantially in the direction of the common axis (A).

10. The assembly according to any one of claims 1 to 9, wherein the proximity sensor (420') comprises at least two optical light emitters (422, 422').

11. An electronic device comprising the assembly of any one of claims 1 to 10.

12. A method for forming an assembly (200, 300, 400) comprising a display screen (110) having a plurality of pixels (10) arranged in a matrix scheme comprising rows (14) orientated in a first direction (X) and columns (15) orientated in a second direction (Y), and a proximity sensor (220, 320, 420, 420'); the display screen being an OLED screen, each pixel of the OLED screen having a subpixel arrangement; the proximity sensor having at least one optical light emitter (222, 322, 422, 422') and an optical detector (224, 324, 424); the method comprising: placing the proximity sensor under the display screen, such that each of the at least one optical light emitter is adapted to emit a light beam through one or more first pixels of the display screen, the optical detector (224, 324, 424) is adapted to receive through one or more second pixels of the display screen the light beam emitted by the at least one emitter and reflected on an object, none of the one or more second pixels being in the same row as any of the one or more first pixels, and none of the one or more second pixels being in the same column as any of the one or more first pixels.

13. The method of claim 12 comprising:
- providing the proximity sensor (220) having the at least one optical light emitter (222) and the optical detector (224) both housed within an optical package (226), each common axis (A) passing through the center of one of the at least one optical light emitter and the center of the optical detector being substantially aligned with an edge of the optical package;
- positioning the proximity sensor (220) under the display screen (110);
- rotating the proximity sensor (220) in order to offset the edge of the optical package with regard to each of the first and second directions (X, Y) by an acute angle of at least 10° and at most 80°; and
- assembling the proximity sensor (220) to the display screen (110).

14. The method of claim 12 comprising:
- providing the proximity sensor (320, 420, 420') having the at least one optical light emitter (322, 422, 422') and the optical detector (324, 424) both housed within an optical package (326, 426), each common axis (A, A') passing through the center of one of the at least one optical light emitter and the center of the optical detector being offset with regard to each of the edges of the optical package by an acute angle of at least 10° and at most 80°; and
- assembling the proximity sensor (320, 420, 420') under the display screen (110) so that each of the edges of the optical package is substantially aligned with the first direction (X) or the second direction (Y).

## Patentansprüche

1. Eine Baugruppe (200, 300, 400) für eine elektronische Einrichtung, wobei die Baugruppe das Folgendes aufweist:
- einen Anzeigebildschirm (110), der eine Vielzahl von Pixeln (10) aufweist, die in einem Matrixschema angeordnet sind, das Zeilen (14), die in einer ersten Richtung (X) orientiert sind, und Spalten (15), die in einer zweiten Richtung (Y) orientiert sind, aufweist; wobei der Anzeigebildschirm ein OLED-Bildschirm ist, wobei jedes Pixel des OLED-Bildschirms eine Subpixel-Anordnung hat; und
- einen Näherungssensor (220, 320, 420, 420'), der wenigstens einen optischen Lichtsender (222, 322, 422, 422'), der jeweils eingerichtet ist zum Emittieren eines Lichtstrahls durch ein oder mehrere erste Pixel des Anzeigebildschirms, und einen optischen Detektor (224, 324, 424) aufweist, der eingerichtet ist zum Empfangen, durch ein oder mehrere zweite Pixel des Anzeigebildschirms, des von dem wenigstens einen optischen Lichtsender emittierten und an einem Objekt reflektierten Lichtstrahls;
wobei keines der ein oder mehreren zweiten Pixel in derselben Zeile wie eines der ein oder mehreren ersten Pixel ist, und keines der ein oder mehreren zweiten Pixel in derselben Spalte wie eines der ein oder mehreren ersten Pixel ist.

2. Die Baugruppe (200, 300, 400) nach Anspruch 1, wobei jede gemeinsame Achse (A, A'), die durch den Mittelpunkt eines der wenigstens einen optischen Lichtsender (222, 322, 422, 422') und den Mittelpunkt des optischen Detektors (224, 324, 424) verläuft, gegenüber jeder der ersten und zweiten Richtungen (X, Y) um einen spitzen Winkel von wenigstens 10° und höchstens 80° versetzt ist.

3. Die Baugruppe nach Anspruch 2, wobei ein erster spitzer Winkel (α, α') der gemeinsamen Achse (A, A') gegenüber der ersten Richtung (X) zwischen 10° und 45° liegt.

4. Die Baugruppe nach Anspruch 2, wobei ein zweiter spitzer Winkel (β) der gemeinsamen Achse (A) gegenüber der zweiten Richtung (Y) zwischen 10° und 45° liegt.

5. Die Baugruppe nach einem der Ansprüche 1 bis 4, wobei die Subpixel-Anordnung eine Pentile-Subpixel-Anordnung ist.

6. Die Baugruppe (200) nach einem der Ansprüche 1 bis 5, wobei der wenigstens eine optische Lichtsender (222) und der optische Detektor (224) in einem optischen Gehäuse (226) untergebracht sind, und jede gemeinsame Achse (A), die durch den Mittelpunkt eines der wenigstens einen optischen Lichtsender und den Mittelpunkt des optischen Detektors verläuft, im Wesentlichen an einer Kante des optischen Gehäuses ausgerichtet ist.

7. Die Baugruppe (300, 400) nach einem der Ansprüche 1 bis 6, wobei der wenigstens eine optische Lichtsender (322, 422, 422') und der optische Detektor (324, 424) in einem optischen Gehäuse (326, 426) untergebracht sind, und jede gemeinsame Achse (A, A'), die durch den Mittelpunkt eines der wenigstens einen optischen Lichtsender und den Mittelpunkt des optischen Detektors verläuft, gegenüber jeder der Kanten des optischen Gehäuses um einen spitzen Winkel von wenigstens 10° und höchstens 80° versetzt ist.

8. Die Baugruppe (400) nach Anspruch 7, wobei das optische Gehäuse (426) im Wesentlichen rechteckig oder quadratisch ist, und wenigstens eine gemeinsame Achse (A) im Wesentlichen in einer Diagonale des optischen Gehäuses orientiert ist.

9. Die Baugruppe (400) nach Anspruch 8, wobei der optische Detektor (424) ein Array von lichtempfindlichen Pixeln aufweist, das Zeilen und Spalten von lichtempfindlichen Pixeln hat, wobei der optische Detektor orientiert ist, um die Zeilen der lichtempfindlichen Pixel oder die Spalten der lichtempfindlichen Pixel im Wesentlichen in der Richtung der gemeinsamen Achse (A) auszurichten.

10. Die Baugruppe nach einem der Ansprüche 1 bis 9, wobei der Näherungssensor (420') wenigstens zwei optische Lichtsender (422, 422') aufweist.

11. Eine elektronische Einrichtung, die die Baugruppe nach einem der Ansprüche 1 bis 10 aufweist.

12. Ein Verfahren zum Ausbilden einer Baugruppe (200, 300, 400), die einen Anzeigebildschirm (110) mit einer Vielzahl von Pixeln (10) aufweist, die in einem Matrixschema angeordnet sind, das Zeilen (14), die in einer ersten Richtung (X) orientiert sind, und Spalten (15), die in einer zweiten Richtung (Y) orientiert sind, und einen Näherungssensor (220, 320, 420, 420') aufweist; wobei der Anzeigebildschirm ein OLED-Bildschirm ist, wobei jedes Pixel des OLED-Bildschirms eine Subpixel-Anordnung hat; wobei der Näherungssensor wenigstens einen optischen Lichtsender (222, 322, 422, 422') und einen optischen Detektor (224, 324, 424) hat;
wobei das Verfahren Folgendes aufweist: Platzieren des Näherungssensors unter dem Anzeigebildschirm, derart, dass jeder der wenigstens einen optischen Lichtsender eingerichtet ist zum Emittieren eines Lichtstrahls durch ein oder mehrere erste Pixel des Anzeigebildschirms, der optische Detektor (224, 324, 424) eingerichtet ist zum Empfangen des von dem wenigstens einen Sender emittierten und an einem Objekt reflektierten Lichtstrahls durch ein oder mehrere zweite Pixel des Anzeigebildschirms, wobei keines der ein oder mehreren zweiten Pixel in derselben Zeile wie eines der ein oder mehreren ersten Pixel ist, und keines der ein oder mehreren zweiten Pixel in derselben Spalte wie eines der ein oder mehreren ersten Pixel ist.

13. Das Verfahren nach Anspruch 12, das Folgendes aufweist:
- Bereitstellen des Näherungssensors (220), der den wenigstens einen optischen Lichtsender (222) und den optischen Detektor (224) hat, die beide in einem optischen Gehäuse (226) untergebracht sind, wobei jede gemeinsame Achse (A), die durch den Mittelpunkt eines der wenigstens einen optischen Lichtsender und den Mittelpunkt des optischen Detektors verläuft, im Wesentlichen an einer Kante des optischen Gehäuses ausgerichtet ist;
- Positionieren des Näherungssensors (220) unter dem Anzeigebildschirm (110);
- Drehen des Näherungssensors (220), um die Kante des optischen Gehäuses gegenüber jeder der ersten und zweiten Richtungen (X, Y) um einen spitzen Winkel von wenigstens 10° und höchstens 80° zu versetzen; und
- Zusammenbauen des Näherungssensors (220) mit dem Anzeigebildschirm (110).

14. Das Verfahren nach Anspruch 12, das Folgendes aufweist:
- Bereitstellen des Näherungssensors (320, 420, 420'), der den wenigstens einen optischen Lichtsender (322, 422, 422') und den optischen Detektor (324, 424) hat, die beide in einem optischen Gehäuse (326, 426) untergebracht sind, wobei jede gemeinsame Achse (A, A'), die durch den Mittelpunkt eines der wenigstens einen optischen Lichtsender und den Mittelpunkt des optischen Detektors verläuft, gegenüber jeder der Kanten des optischen Gehäuses um einen spitzen Winkel von wenigstens 10° und höchstens 80° versetzt ist; und
- Zusammenbauen des Näherungssensors (320, 420, 420') unter dem Anzeigebildschirm (110), so dass jede der Kanten des optischen Gehäuses im Wesentlichen an der ersten Richtung (X) oder der zweiten Richtung (Y) ausgerichtet ist.

## Revendications

1. Ensemble (200, 300, 400) pour un dispositif électronique, l'ensemble comprenant :
- un écran d'affichage (110) comprenant une pluralité de pixels (10) disposés selon un schéma matriciel comprenant des lignes (14) orientées dans une première direction (X) et des colonnes (15) orientées dans une deuxième direction (Y) ; l'écran d'affichage étant un écran OLED, chaque pixel de l'écran OLED ayant par exemple un agencement de sous-pixels ; et
- un capteur de proximité (220, 320, 420, 420') comprenant au moins un émetteur de lumière optique (222, 322, 422, 422'), chacun étant adapté pour émettre un faisceau lumineux au moyen d'un ou de plusieurs premiers pixels de l'écran d'affichage, et un détecteur optique (224, 324, 424) adapté pour recevoir au moyen d'un ou de plusieurs deuxièmes pixels de l'écran d'affichage le faisceau lumineux émis par l'au moins un émetteur de lumière optique et réfléchi sur un objet ;
dans lequel aucun des un ou plusieurs deuxièmes pixels ne se trouve sur la même ligne qu'aucun des un ou plusieurs premiers pixels, et aucun des un ou plusieurs deuxièmes pixels ne se trouve dans la même colonne qu'aucun des un ou plusieurs premiers pixels.

2. Ensemble (200, 300, 400) selon la revendication 1, dans lequel chaque axe commun (A, A') passant par le centre d'un parmi l'au moins un émetteur de lumière optique (222, 322, 422, 422') et le centre du détecteur optique (224, 324, 424) est décalé par rapport à chacune des première et deuxième directions (X, Y) d'un angle aigu d'au moins 10° et d'au plus 80°.

3. Ensemble selon la revendication 2, dans lequel un premier angle aigu (α, α') de l'axe commun (A, A') par rapport à la première direction (X) est compris entre 10° et 45°.

4. Ensemble selon la revendication 2, dans lequel un deuxième angle aigu (β) de l'axe commun (A) par rapport à la deuxième direction (Y) est compris entre 10° et 45°.

5. Ensemble selon l'une quelconque des revendications 1 à 4, dans lequel l'agencement de sous-pixels est un agencement de sous-pixels en PenTile.

6. Ensemble (200) selon l'une quelconque des revendications 1 à 5, dans lequel l'au moins un émetteur de lumière optique (222) et le détecteur optique (224) sont logés à l'intérieur d'un boîtier optique (226), et chaque axe commun (A) passant par le centre d'un parmi l'au moins un émetteur de lumière optique et le centre du détecteur optique est sensiblement aligné avec un bord du boîtier optique.

7. Ensemble (300, 400) selon l'une quelconque des revendications 1 à 6, dans lequel l'au moins un émetteur de lumière optique (322, 422, 422') et le détecteur optique (324, 424) sont logés à l'intérieur d'un boîtier optique (326, 426), et chaque axe commun (A, A') passant par le centre d'un parmi l'au moins un émetteur de lumière optique et le centre du détecteur optique est décalé par rapport à chacun des bords du boîtier optique d'un angle aigu d'au moins 10° et d'au plus 80°.

8. Ensemble (400) selon la revendication 7, dans lequel le boîtier optique (426) est sensiblement rectangulaire ou carré, et au moins un axe commun (A) est sensiblement orienté sensiblement selon une diagonale du boîtier optique.

9. Ensemble (400) selon la revendication 8, dans lequel le détecteur optique (424) comprend une matrice de pixels photosensibles comportant des lignes et des colonnes de pixels photosensibles, ledit détecteur optique étant orienté afin d'aligner lesdites lignes de pixels photosensibles ou lesdites colonnes de pixels photosensibles sensiblement selon la direction de l'axe commun (A).

10. Ensemble selon l'une quelconque des revendications 1 à 9, dans lequel le capteur de proximité (420') comprend au moins deux émetteurs de lumière optique (422, 422').

11. Dispositif électronique comprenant l'ensemble selon l'une quelconque des revendications 1 à 10.

12. Procédé de formation d'un ensemble (200, 300, 400) comprenant un écran d'affichage (110) ayant une pluralité de pixels (10) disposés selon un schéma matriciel comprenant des lignes (14) orientées dans une première direction (X) et des colonnes (15) orientées dans une deuxième direction (Y), et un capteur de proximité (220, 320, 420, 420') ; l'écran d'affichage étant un écran OLED, chaque pixel de l'écran OLED ayant par exemple un agencement de sous-pixels ; le capteur de proximité comprenant au moins un émetteur de lumière optique (222, 322, 422, 422') et un détecteur optique (224, 324, 424) ;
le procédé comprenant : le placement du capteur de proximité sous l'écran d'affichage, de sorte que chacun parmi l'au moins un émetteur de lumière optique soit adapté pour émettre un faisceau lumineux au moyen d'un ou de plusieurs premiers pixels de l'écran d'affichage, le détecteur optique (224, 324, 424) étant adapté pour recevoir au moyen d'un ou de plusieurs deuxièmes pixels de l'écran d'affichage le faisceau lumineux émis par l'au moins un émetteur et réfléchi sur un objet, aucun des un ou plusieurs deuxièmes pixels n'étant sur la même ligne qu'aucun des un ou plusieurs premiers pixels, et aucun des un ou plusieurs deuxièmes pixels n'étant sur la même colonne qu'aucun des un ou plusieurs premiers pixels.

13. Procédé selon la revendication 12, comprenant :
- la fourniture du capteur de proximité (220) muni de l'au moins un émetteur de lumière optique (222) et du détecteur optique (224), logés tous les deux à l'intérieur d'un boîtier optique (226), chaque axe commun (A) passant par le centre de l'un parmi l'au moins un émetteur de lumière optique et le centre du détecteur optique étant sensiblement aligné avec un bord du boîtier optique ;
- le positionnement du capteur de proximité (220) sous l'écran d'affichage (110) ;
- la rotation du capteur de proximité (220) afin de décaler le bord du boîtier optique par rapport à chacune des première et deuxième directions (X, Y) d'un angle aigu d'au moins 10° et d'au plus 80° ; et
- l'assemblage du capteur de proximité (220) à l'écran d'affichage (110).

14. Procédé selon la revendication 12 comprenant :
- la fourniture du capteur de proximité (320, 420, 420') muni de l'au moins un émetteur de lumière optique (322, 422, 422') et du détecteur optique (324, 424), logés tous les deux à l'intérieur d'un boîtier optique (326, 426), chaque axe commun (A, A') passant par le centre d'un parmi l'au moins un émetteur de lumière optique et le centre du détecteur optique étant décalé par rapport à chacun des bords du boîtier optique d'un angle aigu d'au moins 10° et d'au plus 80° ; et
- l'assemblage du capteur de proximité (320, 420, 420') sous l'écran d'affichage (110) de sorte que chacun des bords du boîtier optique soit sensiblement aligné avec la première direction (X) ou la deuxième direction (Y).
